# EUROPEAN PATENT SPECIFICATION

(11) **EP 0 363 007 B1**
(45) Date of publication and mention of the grant of the patent: **01.06.1994**
(21) Application number: 89308874.0
(22) Date of filing: 01.09.1989
(51) Int. Cl.: H01S 3/085, H01S 3/025

(54) **A semiconductor laser device**
Halbleiterlaser-Vorrichtung
Dispositif laser à semi-conducteur

(30) Priority: 07.10.1988 JP 254345/88
(43) Date of publication of application: 11.04.1990
(73) Proprietor: MITSUBISHI DENKI KABUSHIKI KAISHA, Tokyo (JP)
(72) Inventor: Ikeda, Kenji c/o Mitsubishi Denki K.K. LSI, Itami-shi Hyogo-ken (JP); Shigihara, Kimio c/oMitsubishi Denki K.K. LSI, Itami-shi Hyogo-ken (JP); Mihashi, Yutaka c/oMitsubishi Denki K.K. LSI, Itami-shi Hyogo-ken (JP)
(74) Representative: Beresford, Keith Denis Lewis

(56) References cited:
- US-A- 4 001 719
- US-A- 4 100 508
- JAPANESE JOURNAL OF APPLIED PHYSICS, vol. 18, no. 5, May 1979, pages 967-974, Tokyo, JP; C. NINAGAWA et al.: "Mirror reflectivity dependence of transverse-modes in semiconductor lasers"
- JOURNAL OF APPLIED PHYSICS, vol. 48, no. 7, July 1977, pages 3122-3124, New York, US; J.P. WITTKE et al.: "Lateral mode selection in semiconductor injection lasers"
- XEROX DISCLOSURE JOURNAL, vol. 7, no. 5, September/October 1982, page 347, Stamford, Conn., US; R.D. BURNHAM et al.: "Integrated selective mirror structures on diode lasers"

## Description

### FIELD OF THE INVENTION

The present invention relates to a semiconductor laser device, and more particularly to that capable of obtaining a fundamental transverse mode oscillation at high output.

### BACKGROUND OF THE INVENTION

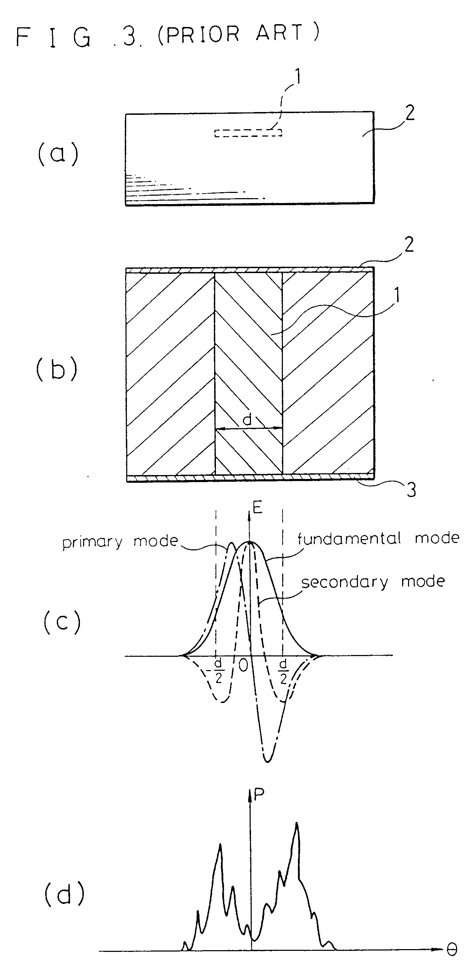

Figures 3(a) to 3(d) show a construction and an operation of a prior art semiconductor laser device. In figure 3, reference numeral 1 designates a semiconductor light waveguide path which generally corresponds to an active region. Reference numerals 2 and 3 designate coating layers at the cavity facets, and dielectric thin films are generally used therefor. Light is amplified with transmitting through the light waveguide path 1. When the light reaches the facet 2, a portion thereof is emitted to the outside and the remaining portion thereof is reflected and again amplified with transmitting through the light waveguide path 1. When the light reaches the facet 3, a portion thereof is emitted to the outside and the remaining portion thereof is again reflected and transmits through the light waveguide path 1.

When the width d of the light waveguide path 1 shown in figure 3 is wide and a primary mode or a secondary mode are allowed other than the fundamental mode (0 order mode), the oscillation mode becomes unstable due to ununiformity of thickness and composition of the light waveguide path, ununiformity of injection current density, and ununiformity of temperature rise. Thus, in some cases a fundamental mode oscillation is obtained but in other cases a primary order mode or a secondary order mode are obtained.

Figure 3(c) shows an electric field distribution (transverse mode) of the zero order, the primary order, and the secondary order mode in the light waveguide path.

When the light waveguide path is widened to about 100 microns in order to obtain a high output, a variety of higher order modes oscillate at the same time, and then a far-field pattern of a complicated configuration such as one having a plurality of peaks is obtained as shown in figure 3(d).

The prior art semiconductor laser device is constituted as described above, and when the width of the light waveguide path is widened to the extent that the higher order transverse mode is allowed in order to obtain a high output, the laser beam cannot be focused on a point due to the generation of higher order transverse mode oscillations which is influenced by the plurality of uncontrollable ununiformity. Furthermore, the ratio of the light which is incident to the optical system to the total light output is low, and furthermore, even in the same laser device the manner of transverse mode oscillation varies and the laser behaviour varies to a great extent dependent on the variations of the injection current and the peripheral temperature, whereby no linearity and no reproducibility of the characteristics is obtained.
Journal of Applied Physics, Volume 48, No. 7, July 1977, Pages 3122-3124, Wittke et al discloses a semiconductor laser device formed from a double heterojunction structure so as to sustain only one transverse mode, as confirmed by far-field radiation patterns. The device is provided with quarter wavelength antireflection coating on the output facet, defining a central reflective stripe forming a mode-selecting mirror. By such an arrangement control of the lateral modes of the output of the device is achieved.
Japanese Journal of Applied Physics, Volume 18, No. 5, May 1979, Pages 967-974 by Ninagawa et al discloses a semiconductor laser device including an antireflective coating deposited on the right and left outer regions of the front facet of the device. This confines laser oscillation to the central narrow portion of the active layer of the device so as to obtain a single transverse-mode.

### SUMMARY OF THE INVENTION

The present invention is directed to solving the above-described problems and has for its object to provide a semiconductor laser device capable of obtaining a high light output and capable of controlling the transverse mode.

Other objects and advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

According to the present invention there is provided a semiconductor laser device provided with a broad light waveguide path through which a higher order transverse mode can be propagated, wherein at least one end facet of the light waveguide path has a reflectance profile in which reflectance is highest at the centre thereof, thereby inhibiting the emission of the higher order transverse mode, the laser device being characterised in that said one end facet has a high reflectance region having a width of about one fifth to one half of the width of said light waveguide path located at a central portion thereof and a low reflectance region having a lower reflectance than said high reflectance region located at both sides of the high reflectance region.

### BRIEF DESCRIPTION OF THE DRAWINGS

Figures 1(a) and (b) are diagrams showing a perspective view and a cross-sectional view of a semiconductor laser device according to a first embodiment of the present invention;
Figure 2 is a diagram showing a far field pattern according to the first embodiment of Figure 1;
Figures 3(a) to (d) are diagrams showing a prior art semiconductor laser device;
Figures 4(a) and (b) are diagrams showing a semiconductor laser device according to a second embodiment of the present invention; and
Figures 5 to 8 are diagrams showing the relationships between the ratio of the higer order mode reflectance to the fundamental mode reflectance and the width of the high reflectance region in the semiconductor laser device having the width of the light waveguide path of 150 microns, 20 microns, 30 micros, and 50 microns, respectively.

### DETAILED DESCRIPTION OF THE PREFERRED EMBODIMENTS

An embodiment of the present invention will be described in detail with reference to the drawings.

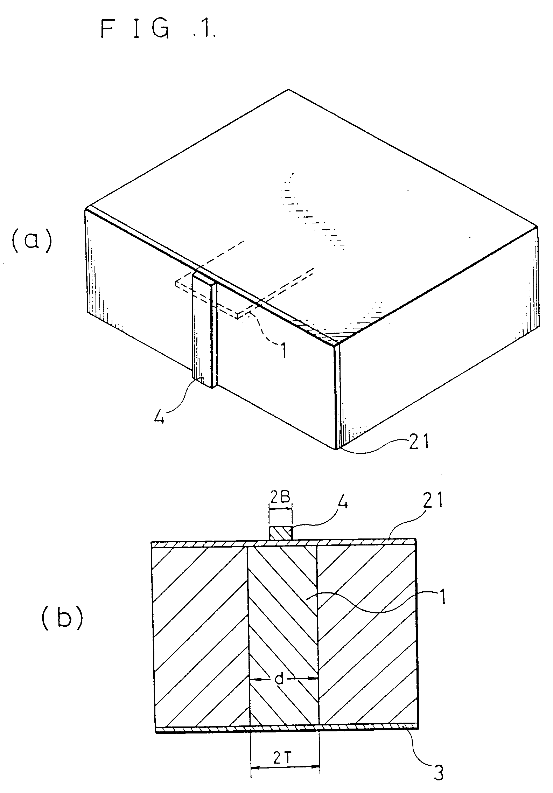

Figure 1 shows a semiconductor laser device according to a first embodiment of the present invention, and figure 1(a) shows a perspective view thereof and figure 1(b) is a diagram viewed from the above toward the surface of light waveguide path, showing the principle oscillation. In figure 1, reference numeral 1 designates a light waveguide path, reference numeral 3 designates a rear facet coating layer, reference numeral 21 designates a low reflectance coating layer at the front facet. A high reflectance region 4 is produced at the central portion of the light waveguide path 1.

The device will operate as follows.

In the semiconductor laser device having a wide light waveguide path, quite a lot of transverse modes such as a zero order, a primary order, a secondary order, ... are allowed to propagate. Furthermore, there is almost no difference due to the order number in the gains which are obtained in these transverse modes. Accordingly, if the reflection at the facet is uniform, whether any of these transverse modes will arise depends on this slight difference in the modal gain. Usually, the 0 order mode is likely to oscillate, but transverse modes in a variety of order numbers will oscillate because the ununiformity slightly existes as described above.

In the present invention, the facet reflectances of the respective transverse modes having different order numbers largely differ from each other, and a high reflectance is obtained only at the central portion of the light waveguide path and low reflectances are obtained at the other portion. Therefore, in the zero order mode having a large power distribution at the central portion, the reflectance is higher than that in the other higher order mode. Accordingly, the threshold value becomes higher at the higher order mode, and oscillation will not easily occur at such higher order mode.

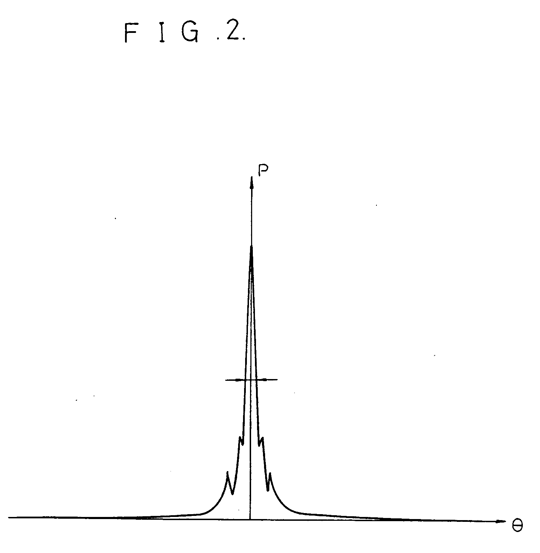

Figure 2 shows an example of a far field pattern of a semiconductor laser device of this embodiment. This far field pattern shows a narrow half value angle of about 1.5 degree and a configuration having one large peak at about the central portion. This means that a fundamental mode oscillation is conducted. Two small shoulders or peaks are seen at the both sides, respectively, and these are considered to be fringes which are produced by that the light is diffracted and interfered at the boundary between the high reflectance portion and the low reflectance portion.

The width of the high reflectance portion 4 will be considered. In a case where an AlGaAs laser of an SBA (self-aligned bent active layer) type having Al_{0.15}Ga_{0.85}As active layer of 0.06 microns thickness and an Al_{0.45}Ga_{0.55}As cladding layer is assumed, when the width 2T of the active region, that is, the width of the light waveguide path is 150 microns, the transverse modes allowed then are the zero order, primary order, ... 98th order. Among these transverse modes, if the fundamental mode has a sufficiently low threshold value as compared with the other modes, the fundamental transverse mode can be selectively oscillated.

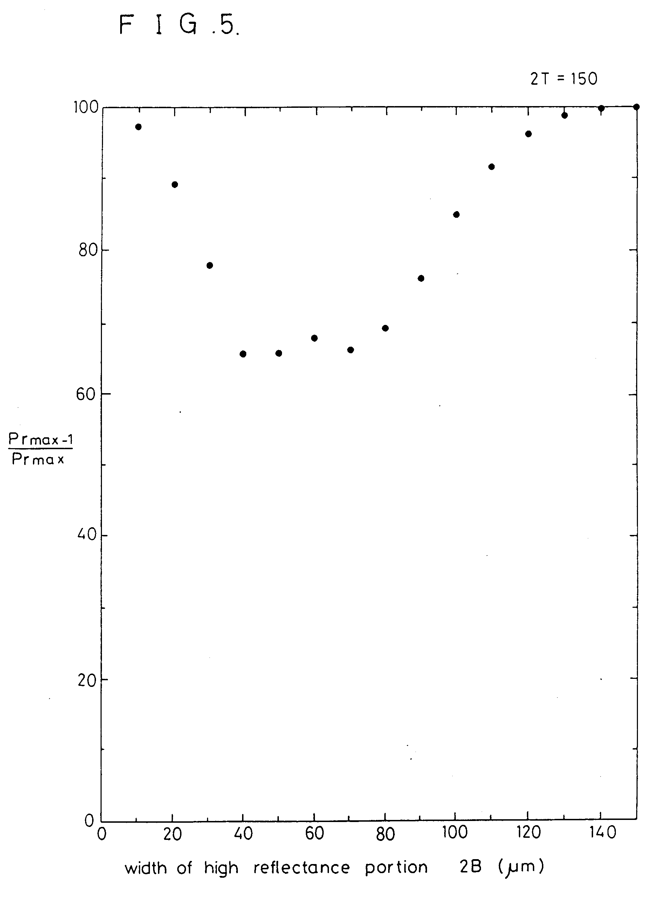

Figure 5 shows a ratio of the reflectance against the fundamental (zero order) mode (overlapping integral of the standardized fundamental mode waveform and the rectangle of width 2B) to the reflectance against the mode having a secondary large reflectance (overlapping integral of the higher order mode other than the standardized fundamental mode and the rectangle of width 2B) in a semiconductor laser in which the width 2T is 150 microns, a dielectric film coating of reflectance Rf is conducted to the region of width 2B at the central portion, and the reflectance of the other portions is 0 %. The number 100 % means that there is no mode selectivity, and it shows that the zero order mode is likely to be selected as the value is smaller. From this figure, when the width 2B of the high reflectance region 4 is 40 to 70 microns against the width 2T of the active region (150 microns), the selectivity is enhanced.

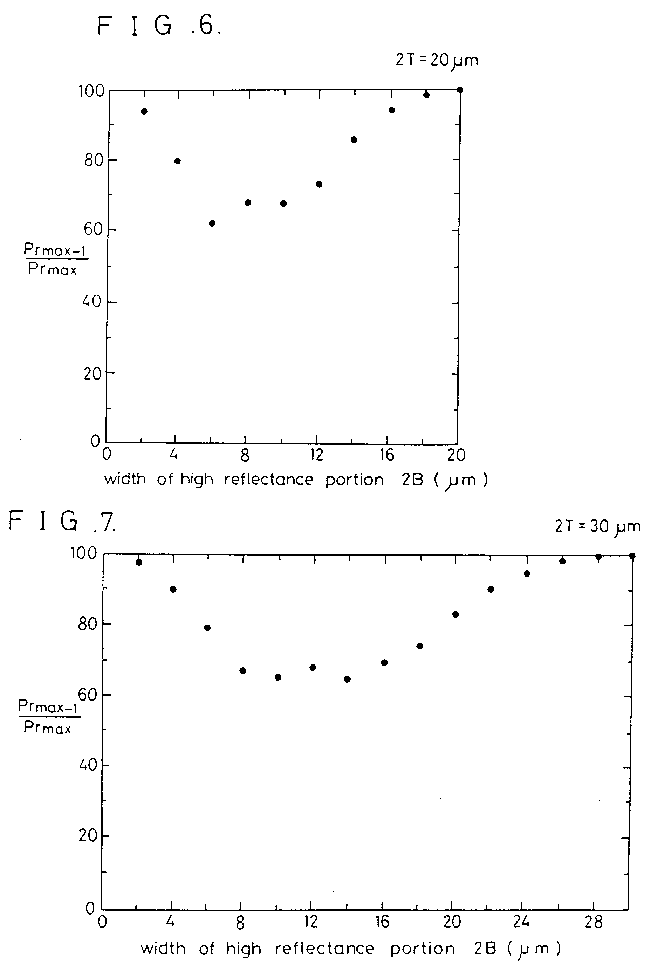

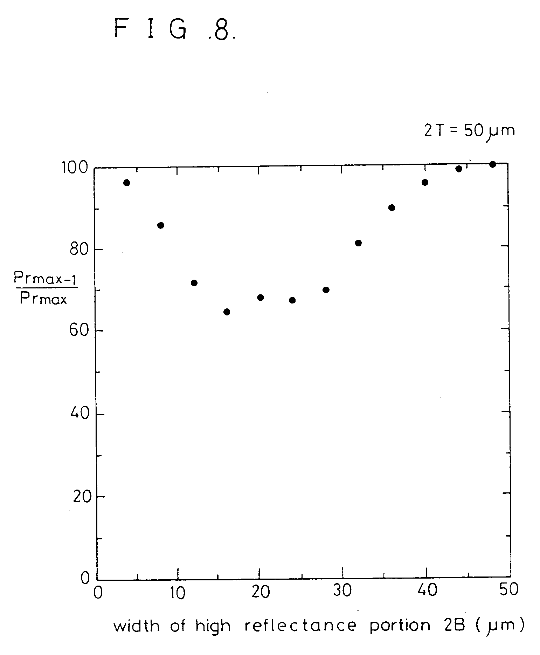

The similar calculation is conducted on cases where the width 2T of the active region is 20 microns, 30 microns, and 50 microns, and the respective properties are shown in figures 6, 7, and 8. In all cases, when the portion of about 1/3 of width 2T of the active region is made a high reflectance portion 4, the reflectance of the mode which is likely to oscillate followed by the fundamental mode can be reduced to about 60 to 70 % as compared with the reflectance of the fundamental mode similarly as in the case of figure 5. As seen from this fact, the width of the high reflectance portion 4 is most effective to be made about 1/5 to 1/2 of the width of the laser waveguide path 1.

The threshold gain g in a semiconductor laser of front facet reflectance Rf, rear facet reflectance Rr, scattering and absorption loss α (cm⁻¹), and cavity length L is approximately given by the following formula. 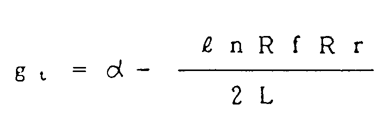
When the SBA laser having an active region of 150 microns width is considered, α = 10 cm⁻¹, L = 500 microns, and a threshold gain of ${\text{g}}_{\text{t0}} \text{= 10 - 10 ℓ n (Rf Rr)}$ is required against the fundamental mode. On the contrary, when a high reflectance portion of 50 microns width corresponding to 1/3 of 150 microns is produced, as seen from figure 5, the front facet reflectance against the mode (mode X) which is likely to oscillate followed by the fundamental mode becomes 0.655 Rf of that against the fundamental mode, and the gain gₜₓ required for the oscillation at the mode X is given by the following formula. 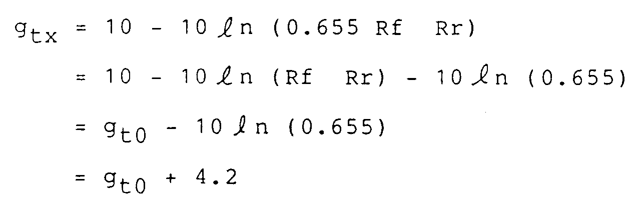
As seen from this formula, the gain gₜ is larger by 4.2 cm⁻¹ than the threshold gain required against the fundamental mode. This gain difference of 4.2 cm⁻¹ is a value sufficient against the unexpectable disturbances such as errors in the processing and ununiformity in the crystal, and a fundamental mode oscillation can be surely obtained.

Next, the production method of the facet reflectance film in the present embodiment will be described.

The production method of the facet reflectance film in the present embodiment is fundamentally the same as the usual production method. However, there is only difference in that the high reflectance portion is produced only at a portion of the facet. Since a low reflectance coating is executed and thereafter a high reflectance portion is portionally produced in a usual production method, the following description will be also conducted in this order.

When the refractive index of the dielectric material for coating is √N̅e̅f̅f̅ (herein, Neff is an equivalent refractive index in the semiconductor crystal for the mode under consideration, and in AlGaAs series lasers it is generally 3.4 to 3.5), by making the thickness of the dielectric material film 1/4 wavelength of the wavelength λ₀ of the light under consideration or a value of odd number multiple thereof, the reflectance can be made the lowest value, that is, zero. For example, against an oscillation light of 0.8 microns wavelength, by making the thickness of the dielectric material film having refractive index of 1.85 to be 0.108 microns or 0.324 microns..., the reflectance can be made zero. Al₂O₃ (N ≒ 1.76) or Si₃N₄ (N ≒ 1.9) can be employed for the dielectric material film. These material is deposited to a desired thickness on a facet of a semiconductor laser device by an electron beam deposition method or a plasma CVD method, thereby producing a low reflectance portion 21.

The high reflectance portion 4 is produced by a multi-layer coating of SiO₂ and a-Si (amorphous silicon), and usually the reflectance up to about 95 % can be easily obtained with several layers. In order to produce this multi-layer at a desired portion of the laser facet with controlling the width thereof, at first a wafer is cleaved to arrange a plurality of laser chips in a bar state, and this is fixed onto a flat surface such as glass plate with making a facet on which the layer coating is conducted directed toward upwards. A resist may be used for the fixation. Next, the low reflectance coating layer 21 is produced on the facet followed by to the above-described production process. Next, resist is plated on the entire surface thereof, and light exposure of a desired width is conducted onto a central portion of stripe (active layer). A development is conducted to remove the resist only at the light exposure portion, and the above-described SiO₂/a-Si layer is deposited on the bar of this state by such as electron beam deposition method. Thereafter, the remaining resist is removed by a solvent such as acetone, and the SiO₂/a-Si layer deposited on the resist are removed together with the resist, thereby producing a SiO₂/a-Si layer only at the central portion of the stripe.

The most difficult point in this method resides in how the pattern is accurately aligned at the central portion of the stripe having 150 microns width. Although the stripe can be easily seen from the pattern surface of the bar, when the patterning is conducted onto the facet, it is hardly seen. Therefore, a mesa etching for separating the chips from each other is previously conducted in the wafer state. Then, the mesa etched position can be seen in a V groove configuration from the facet direction in the bar state, and the judgment can be easily conducted. Accordingly, when the pattern is aligned with this mesa etched portion, a pattern of a desired width can be baked at the central portion of each stripe automatically.

In this embodiment, since a photolithography is conducted with plating a resist on the facet, the control of the resist thickness is more difficult with relative to the usual case, and the precision of the pattern width becomes about + 3 microns. Furthermore, since the position of the pattern is aligned with the V-shaped groove produced by the mesa etching, the positional precision will be ± 2 microns. However, as shown in figure 5, an error of ± 10 to ± 15 microns can be allowed for the width of the high reflectance portion, and if the width is within the above-described precision, there arises no problem.

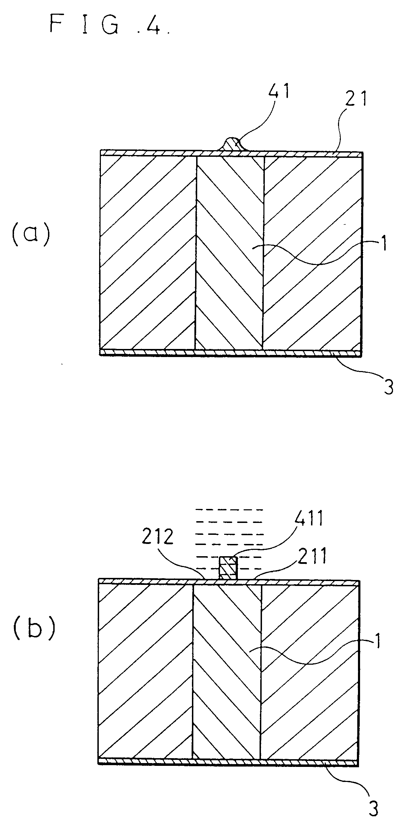

Figures 4(a) and (b) show other embodiments of the present invention, respectively.

In the embodiment of figure 1, the left and right side surfaces of the high reflectance portions 4 are made vertically to the facet of the laser, thereby resulting in fringes in far field pattern as shown in figure 2. In the embodiment of figure 4(a), however, the side surfaces of the high reflectance portion 41 are made to have easy slopes, thereby reducing the fringes.

In the embodiment of figure 4(b), while the thickness of the high reflectance portions 411 are made thickness having a desired reflectance, the reflectance of the low reflectance portions 211 and 212 and that of the high reflectance portion 411 are properly adjusted and the wave fronts of the light emitted from the both portions are aligned, thereby reducing the above-described fringes. That is, the high reflectance portion 411 generally arises reflections by the refractive index difference between the high reflectance portion 411 and the outside, and the reflectance of the entire device is determined by the phase relationship between the light which is reflected at the surface of the portion 411 and the light which is reflected at the interface between the layer 411 and the laser crystal. Since this reflectance is periodically heightened and lowered when the thickness of the high reflectance portion 411 is increased, it is possible to obtain a thickness which satisfies a desired reflectance and a thickness which will be described later at the same time.

For example, when a region of high reflectance portion 411 is produced to the thickness of 1.5 microns by material having refractive index of 1.5 against the laser of wavelength 750 nm, the light which is emitted from the low reflectance portions 211 and 212 and propagated through external space corresponds to two wavelengths in 1.5 microns, and the light at 1.5 microns forward form the emission surface has the same phase as the light at the emission surface. On the other hand, the light propagated in the high reflectance portion 411 corresponds to three wavelengths in 1.5 microns, and the light at the emission surface at the high reflectance portion has also the same phase. Accordingly, the light emitted from the high reflectance portion 411 and the light emitted from the low reflectance portions 211 and 212 will become the same phase when these lights are propagated beyond space. Accordingly, the fringes of the far field pattern become small and the light can be effectively concentrated at the center. In other words, the utilization efficiency of the light is heightened.

While in the above-described embodiment a BH (Buried Hetero) type laser is described, the present invention may be applied to lasers having other stripe configurations such as an SBH (Strip Buried Hetero) type laser, an SAS (Self Aligned Structure) type laser, or an electrode stripe type layer.

The reason why the term "light waveguide path" is used not using the term "an active layer" in above description, is because there is no importance in that where the generation and amplification of light are conducted in the present invention but there exists an importance in that how the light is guided. In other words, the present invention may be applied to an LOC structure as a semiconductor laser structure in which the active layer is overlaid on a light guide path, and this active layer is removed at the neighborhood of the cavity facets so as not to expose the active layer at the facets and to expose only the light waveguide path at the facets.

While in the above-illustrated embodiment a photolithography is used for producing a high reflectance region having a narrow width on the laser facet, this region may be produced by direct deposition with using a patterned metal mask. In this case, since the side surface portions of the high reflectance portion is properly sloped, there arises no large fringes in the light of the laser when it is emitted to the outside, and this may be convenient in some cases. However, the positional precision in the deposition mask method is generally worse than that of the above-described photolithography, and it is supposed that the positional precision becomes about + 10 microns.

As is evident from the foregoing description, according to the present invention, at least one facet of a light waveguide path is constituted by a high reflectance region having a width of about 1/5 to 1/2 of the width of the light waveguide path located at the central portion of the light waveguide path and a low reflectance region having a lower reflectance than the high reflectance region located at the both sides of the high reflectance region, and the facet reflectance is made to have a mode selectivity. Accordingly, even in a high output semiconductor laser device having a wide light waveguide path, a fundamental transverse mode oscillation is easily obtained. Thus, when the fundamental mode is obtained, the light can be focused on a point by a lens, and the entire power can be concentrated on a small spot which is determined by the diffraction ability of the optical system, thereby enabling to obtain a fundamental mode oscillation even in an excitation of the laser facet of a solid laser as well as an optical recording, and further enabling a high efficiency wavelength conversion by irradiating such laser light to SGH material.

## Claims

1. A semiconductor laser device provided with a broad light waveguide path (1) through which a higher order transverse mode can be propagated, wherein at least one end facet (3) of the light waveguide path (1) has a reflectance profile in which reflectance is highest at the centre thereof, thereby inhibiting the emission of the higher order transverse mode, the laser device being characterised in that said one end facet (3) has a high reflectance region (4) having a width (2B) of about one fifth to one half of the width (2T) of said light waveguide path (1) located at a central portion thereof and a low reflectance region having a lower reflectance than said high reflectance region located at both sides of the high reflectance region (4).

2. A semiconductor laser device according to Claim 1, in which the centre of said one end facet (3) has a coating (4) of higher reflectivity than the coating (21) on the rest of said one end facet (3).

3. A semiconductor laser device according to either of the preceding claims, wherein the reflectance at the boundary between the high reflection region (4) and the low reflection region of said end facet (3) vary smoothly.

4. A semiconductor laser device according to Claim 3, in which the lateral surfaces of the high reflectance portion (41) are sloped so as to cause said reflectances to vary smoothly.

5. A semiconductor laser device according to Claim 4, wherein the thickness and refractive index of the coating (411) carried by the high reflectance region and the thickness and refractive index of the coating (211, 212), carried by the low reflectance region are chosen such that the wavefronts of the light emitted from both the high reflectance region and the low reflectance region are aligned so as to reduce fringes in the emitted field pattern.

## Patentansprüche

1. Halbleiterlaservorrichtung, welche mit einem breiten Lichtwellenleiterpfad (1) versehen ist, über den eine Transversalmode höherer Ordnung fortgepflanzt werden kann, wobei zumindest eine Endfacette (3) des Lichtwellenleiterpfades (1) ein Reflexionsprofil aufweist, bei dem das Reflexionsvermögen bei der Mitte hiervon am größten ist, wodurch die Emission der Transversalmode höherer Ordnung verhindert ist, wobei sich die Laservorrichtung dadurch auszeichnet, daß die eine Endfacette (3) einen Bereich (4) hohen Reflexionsvermögens mit einer Breite (2B) von etwa einem Fünftel bis zu einer Hälfte der Breite (2T) des Lichtwellenleiterpfades (1) aufweist, der bei einem mittleren Abschnitt hiervon angeordnet ist und einen Bereich geringen Reflexionsvermögens aufweist mit einem geringeren Reflexionsvermögen als der Bereich hohen Reflexionsvermögens, der zu beiden Seiten des Bereiches hohen Reflexionsvermögens (4) angeordnet ist.

2. Halbleiterlaservorrichtung nach Anspruch 1, wobei die Mitte der einen Endfacette (3) eine Beschichtung (4) mit höherer Reflexionskraft als die Beschichtung (21) auf dem Rest der einen Endfacette (3) aufweist.

3. Halbleiterlaservorrichtung nach einem der vorhergehenden Ansprüche, wobei das Reflexionsvermögen an der Grenze zwischen dem Bereich (4) hoher Reflexion und dem Bereich (3) geringer Reflexion der Endfacette (3) übergangslos variiert.

4. Halbleiterlaservorrichtung nach Anspruch 3, bei der die Seitenoberflächen des Abschnitts (41) hohen Reflexionsvermögens solche Neigungen aufweisen, daß dadurch erreicht wird, daß die Reflexionsvermögen übergangslos variieren.

5. Halbleiterlaservorrichtung nach Anspruch 4, wobei die Dicke und der Brechungsindex der von dem Bereich hohen Reflexionsvermögens getragenen Beschichtung (411) und die Dicke und der Brechungsindex der von dem Bereich geringen Reflexionsvermögens getragenen Beschichtung (211, 212) so gewählt sind, daß die Wellenfronten des sowohl aus dem Bereich hohen Reflexionsvermögens als auch aus dem Bereich geringen Reflexionsvermögens emittierten Lichtes so aufeinander ausgerichtet sind, daß Ringe im emittierten Feldmuster verringert sind.

## Revendications

1. Dispositif laser à semi-conducteur pourvu d'un chemin de guide d'ondes optique large (1) à travers lequel un mode transversal d'ordre plus élevé peut être propagé, dans lequel au moins une facette d'extrémité (3) du chemin de guide d'ondes optique (1) présente un profil à pouvoir réflecteur dans lequel la réflectance est la plus élevée au centre de celui-ci, ce qui empêche l'émission du mode transversal d'ordre plus élevé, le dispositif laser étant caractérisé en ce que ladite facette d'extrémité (3) comporte une zone à réflectance élevée (4) ayant une largeur (2B) d'environ un cinquième à la moitié de la largeur (2T) dudit chemin de guide d'ondes optique, positionnée en une partie centrale de celui-ci et une zone à faible réflectance ayant une réflectance inférieure à celle de ladite zone de réflectance élevée, positionnée sur les deux côtés de la zone de réflectance élevée (4).

2. Dispositif laser à semi-conducteur selon la revendication 1, caractérisé en ce que le centre de ladite facette d'extrémité (3) présente un revêtement (4) de réflectivité plus élevée que le revêtement (21) sur le reste de ladite facette d'extrémité (3).

3. Dispositif laser à semi-conducteur selon l'une quelconque des revendications précédentes, caractérisé en ce que la réflectance à la frontière entre la zone de réflexion élevée (4) et la zone à réflexion faible de ladite facette d'extrémité (3) varie doucement.

4. Dispositif laser à semi-conducteur selon la revendication 3, caractérisé en ce que les surfaces latérales de la portion à réflectance élevée (41) sont inclinées de manière à faire varier doucement lesdites réflectances.

5. Dispositif laser à semi-conducteur selon la revendication 4, caractérisé en ce que l'épaisseur et l'indice de réfraction du revêtement (411) supporté par la zone à réflectance élevée et l'épaisseur et l'indice de réfraction du revêtement (211, 212) supporté par la zone a réflectance faible sont choisis de sorte que les fronts d'ondes de la lumière émise à partir à la fois de la zone a réflectance élevée et de la zone à faible réflectance sont alignés de manière à réduire les zones marginales dans le diagramme de rayonnement émis.
